# EUROPEAN PATENT APPLICATION

(11) **EP 3 570 047 A1**
(43) Date of publication of application: **20.11.2019**
(21) Application number: 18172455.0
(22) Date of filing: 15.05.2018
(51) Int. Cl.: G01R 15/04, G01R 15/06

(54) **MODULE AND SYSTEM FOR BUILDING A VOLTAGE DIVIDER FOR SENSING A VOLTAGE**

(71) Applicant: 3M Innovative Properties Company, Saint Paul, MN 55133-3427 (US)
(72) Inventor: Gravermann, Mark, 41812 Erkelenz (DE); Weichold, Jens, 41812 Erkelenz (DE); Stollwerck, Gunther, 47802 Krefeld (DE)
(74) Representative: Müller, Bruno

(57) **Abstract**

The invention relates to a module (1) for building a voltage divider for sensing a voltage of an inner conductor of a high or medium voltage power conductor, wherein the module comprises:
- at least one discrete impedance element (3),
- a first connector (5) and a second connector (6), wherein the second connector is adapted to be mechanically and electrically connected with a connector identical to the first connector of a further module for building the voltage divider according to the invention, and wherein the first connector is adapted to be mechanically and electrically connected with a connector identical to the second connector of a further module for building the voltage divider according to the invention,
- wherein the at least one impedance element is electrically connected with the first and the second connector, and
- wherein the module further comprises mechanical fixing (21) means for fixing the module to a high or medium voltage power conductor.

## Description

The invention relates to a module for building a voltage divider for sensing a voltage of an inner conductor of a high or medium voltage power conductor as well as to a system for building a voltage divider for sensing a voltage of an inner conductor of a high or medium voltage power conductor and a high or medium voltage grid with a high or medium voltage power conductor comprising the system.

Voltage dividers for sensing a voltage of an inner conductor of a high voltage or medium voltage power cable are known, e. g. from the German patent application DE 37 02 735 A1. Voltage dividers can be formed by a plurality of resistors, capacitors or inductances. Resistors, capacitors and inductances are referred to as impedances in this disclosure.

Generally, in a voltage sensor working along the principle of a voltage divider one end of a voltage divider is electrically connected to the power conductor or otherwise kept on a high voltage to be measured, while the opposite end is held on a lower voltage or on earth potential. Voltage dividers formed by a greater number of dividing elements which are connected in series are advantageous because the voltage drop across each of the divider elements is smaller than with only one or two dividing elements, thus reducing electrical stress and risk of failure.

An example of a voltage divider in a high voltage application is shown in the European patent application EP 2 605 023 A1, where the voltage divider comprises a plurality of resistive elements in an angled configuration. The group of elements is arranged on an insulating support the shape of which is such that the creepage distance of the support is equal to or longer than the sum of the creepage distances of the individual resistances. According to EP 2 605 023 A1 the divider can be embedded in insulting material, which is preferably a resin.

The European patent application EP 2 605 416 A1 discloses an electric coupler comprising a voltage divider, a condenser and two terminal contacts. The condenser is elongated and its ends are in contact with the two terminals of the coupling device, occupying an axis parallel to the imaginary central axis of the connector.

It is also known, that an insulating sleeve can be designed to accommodate electric components. The European patent application EP 2 763 259 A1 discloses an insulating sleeve with an electrode section and a PCB carrying a capacitive element of a voltage divider.

The European patent application EP 3 223 024 A1 discloses an elastic sleeve with a divider assembly comprising a plurality of discrete impedance elements, which are electrically connected in series such as to be operable as a voltage divider for sensing a voltage.

The above mentioned sensor arrangements each provide solutions for one specific application. In view of this prior art, there is still a need for a sensing solution that can be adapted very flexible to the according application. There is further still a need for a sensing solution that is easy to manufacture.

The present invention provides a module (base module) for building a voltage divider for sensing a voltage of an inner conductor of a high or medium voltage power conductor, the module comprising:
- at least one discrete impedance element,
- a first connector and a second connector, wherein the second connector is adapted to be mechanically and electrically connected with a connector identical to the first connector of a further module for building the voltage divider according to the invention, and wherein the first connector is adapted to be mechanically and electrically connected with a connector identical to the second connector of a further module for building the voltage divider according to the invention,

- wherein the at least one impedance element is electrically connected with the first and the second connector, and
- wherein the module further comprises mechanical fixing means for fixing the module to a high or medium voltage power conductor.

The module according to the invention provides at least one discrete impedance element placed between two connectors that are adapted to be connected to similar connectors and a mechanical fixing means for fixing the module directly or indirectly to a high or medium voltage power conductor. The module may directly be mounted on an inner conductor of a high or medium voltage power cable. It is also possible that it may be mounted on a sheeting or other components of the power cable so that is only indirectly mounted on the inner conductor.

The module according to the invention provides the advantage that it is connectable to further similar modules. With this property, it is possible to build a voltage divider out of several (base) modules according to the invention that can be used for sensing a voltage of an inner conductor of a high or medium voltage power conductor and that is adaptable to the according application. Depending on the range of voltage being lead through the high or medium voltage conductor, a certain number of modules can be selected and connected with each other in order to build up a voltage divider adapted to the according application. For example for a 30 kilo Volt conductor three 10 kV modules according to the invention can be connected with each other. And for a 10 kilo Volt conductor one 10 kilo Volt module according to the invention can be used.

In other words, the module according to the invention may be used as a module for a system that can easily be adapted to each application. Another advantage of the module according to the invention is that it also provides the possibility for simplifying the production process of voltage dividers for sensing a voltage. Instead of producing one type of sensor for each application, which leads to the need of producing and holding on stock a great variety of types, the same kind sensor modules can be produced and can be used to put according sensor systems together for each application.

According to one embodiment of the invention the module comprises two or more discrete impedance elements that are electrically connected in series as to be operable as a voltage divider for sensing a voltage of an inner conductor of the high or medium voltage power conductor. The plurality of discrete impedance elements may be mechanically connected in series, e. g. such as to form a chain of impedance elements. They may be electrically connected by wires or by conductive traces on a printed circuit board (PCB) or by soldering material. Each impedance element may comprise two contacts for connecting it electrically. It is possible to provide different types of modules with each type of module providing a different voltage level. It is also possible to provide different types of modules with each type of module providing a different number of discrete impedance elements, such as, for example, a first type with only one discrete impedance element, a second type with two discrete impedance elements, a third type with three discrete impedance elements and so forth. It is also possible to only provide one type of modules.

According to another embodiment, the module comprises a printed circuit board carrying the at least one discrete impedance element. The printed circuit board may be flexible or it may be rigid. The kind of printed circuit board may depend on the kind of housing of the module according to the invention. It may be partially flexible and/or partially rigid. The printed circuit board may also carry additional components such as for example the first and the second connector of the module. The printed circuit board may also carry components that are used to provide an over voltage protection.

According to yet another embodiment the module according to the invention comprises an encapsulation body, in which the at least one discrete impedance element as well as the first and the second connector are encapsulated such that the first and the second connector are accessible from the outside of the module. The encapsulation body may at least partially be made out of electrically isolating material. It may also either be made out of rigid or out of flexible material. It may also be made partially out of rigid and/or flexible material. Providing a rigid encapsulation body, for example an encapsulation body made out of an epoxy resin, may provide the advantage of offering a protection for example against mechanical or chemical impacts of the discrete impedance elements of the module. If the encapsulation body is made out of a rigid material, it is possible that the printed circuit board is also made out of a rigid material. If the encapsulation is made out of a flexible material, it is possible that the printed circuit board is also made out of a flexible material. Materials that may be used for the encapsulation body are for example ceramic, epoxy resin, silicon, ethylene propylene diene monomer rubber (EPDM) or a combination thereof. It is also possible to provide a liquid of viscose material. In this case an additional housing for receiving or holding the liquid or viscose material is needed as well.

Being accessible from the outside in the context of this embodiment means that although the module comprises an encapsulation, it is possible to mechanically and electrically connect one module with another module over their first and/or their second connectors. The encapsulation body may provide any shape that allows connecting one module to another.

The module according to the invention may comprise an additional housing enclosing the encapsulation body with the printed circuit board and the electronic components such that the first and the second connector are accessible from the outside of the module. The additional housing may also be at least partially made out of electrically isolating material. The additional housing may also be rigid or it may be flexible. It is also possible that the additional housing is at least partially rigid or at least partially flexible. Being accessible from the outside in the context of this embodiment means that although the module comprises an additional housing, it is possible to mechanically and electrically connect one module with another module over their first and/or second connectors.

According to one embodiment of the invention, the inner encapsulation body may be made out of a rigid material, e. g. an epoxy resin, and the additional housing may be made out of a flexible material, e. g. a silicon. The additional housing may provide additional features or functionalities, such as, for example, mechanical fixing means for fixing the module to a high or medium voltage power conductor, additional isolation features, stress control functionalities or a combination of the above features. All these are known features and functionalities and may all be realized with known and already disclosed techniques.

The additional housing of the module and/or the encapsulation body of the module according to the invention may comprise mechanical fixing means for the module to a high or medium voltage power conductor. Since the module according to the invention may be used for building a voltage divider for sensing a voltage of an inner conductor of a high or medium voltage power conductor, it is advantageous when the module may easily be fixed to the power conductor. Providing mechanical fixing means in or at the additional housing and/or encapsulation body is an easy way of fixing the module to the power conductor. The additional housing may provide the shape of a sleeve that can be pushed onto the high or medium voltage power conductor.

The additional housing and/or the encapsulation body may comprise a receiving space for receiving a section of the high or medium voltage power conductor such that the housing surrounds the high or medium voltage power conductor. The receiving space may provide any kind of shape. It may especially provide a circular shape, which provides an adapted receiving section for a power conductor with a circular cross section. Any other useful shape of the receiving space is possible as well. The receiving space may be open or it may be closed. An open receiving space may provide the advantage that the high or medium voltage cable may be easily inserted, even if the module needs to be installed in a certain distance from a termination. A closed receiving space may provide the advantage of being able to stay on the high or medium voltage cable reliably. The housing with its receiving space may be shrunk down onto the high or medium voltage power cable or it may be pushed onto it.

As an alternative or in addition to the receiving space the additional housing and/or the encapsulation body may provide other mechanical fixing means like a clip or a fastener or screw. Adhesive fastening elements may also be provided. All the mechanical fixing means described here may also be provided at the module itself or at the encapsulation body of the module.

According to one embodiment, the additional housing and/or the encapsulation may comprise the shape of a termination skirt for a high or medium voltage power conductor. A termination skirt is a well-known component in the area of high or medium voltage cable accessories. Termination skirts are usually shaped like a disc with a receiving hole in the middle for receiving the high or medium voltage cable such that in an installed stage the skirt extends essentially perpendicular to the longitudinal axis of the high or medium voltage cable. Termination skirts are used to extend the distance a current must travel from one end of the termination to the other. Termination skirts may be pre-molded with an insulation tube. They can also be designed as a push over an insulation tube accessory. If the additional housing comprises the shape of a termination skirt, it may carry the encapsulation body with the module according to the invention.

Since it is a common praxis to install termination skirts at a termination of a cable, the skirts may be used to hold the modules according to the invention.

The impedance elements of the module according to the invention may comprise one or more resistors, and/or capacitors, and/or inductances. An impedance element of a module according to the invention may be, for example, a resistor, a capacitance or an inductance. A plurality of discrete impedance elements may comprise one resistor and one or more capacitors. A plurality of discrete impedance elements may comprise one resistor and one or more inductances. A plurality of discrete impedance elements may comprise one inductance and one or more capacitors. Resistors, capacitors and inductances are particularly suitable elements to form a voltage divider, because they are readily available at moderate costs. Also, their electrical properties are generally precisely specified. The impedance elements may be arranged as a mixed voltage divider and comprise parallel or serial connections of capacitors and resistors.

It is also possible that each module carries one impedance element. When several modules are connected with each other, the impedance elements are arranged in series.

The discrete impedance elements of the module according to the invention may be arranged in the module as a straight chain or as a z-shaped chain. The arrangement as a straight chain may provide the advantage that the impedance elements are arranged with a maximum distance between each other which reduces the risk of an electrical discharge between impedance elements or between the electrical connections of the impedance elements. The z-shaped arrangement may provide for a compact construction of the impedance elements within the module. Any other geometrical arrangement of the impedance elements in the module is possible as well, such as an s-shaped chain or an arrangement as a flat spiral. The outer shape of the module is generally independent of the arrangement of the impedance elements within the module.

The present invention also provides a module according to any of the above described embodiments in combination with a second module according to any of the above described embodiments, wherein the two modules are mechanically and electrically connected with each other such that their discrete impedance elements are electrically connected in series as to be operable as a voltage divider for sensing a voltage of an inner conductor of the high or medium voltage power conductor. It is also possible to connect more than two modules according to the invention with each other, like for example three modules, four modules or five modules and so forth.

The idea of providing a base module with a defined number of impedance elements provides the possibility of adding as many modules as needed for a specific application in order to build the appropriate voltage divider that may for example be used for sensing the voltage in the high or medium voltage conductor. This reduces the number of predefined modules for building a voltage dividers that need to be manufactured and hold on stock.

The first and the second module may be connected with each other via their first and second connectors. For example the second connector of the first module may be engaged with the first connector of the second module.

The present invention also provides a system for building a voltage divider for sensing a voltage of an inner conductor of a high or medium voltage power conductor, the system comprising:
- at least one module for building a voltage divider for sensing a voltage of a high or medium voltage power conductor according to any of the above described modules,
- at least one high or medium voltage end module providing an electrical connection from one of the first or second connectors of the module and the high or medium voltage conductor of the high voltage power conductor, and
- at least one low voltage end module providing a low voltage impedance element and an electrical connection to ground or low voltage.

The system according to the invention provides in addition to the base module according to the invention at least one high or medium voltage end module that is adapted to establish an electrical connection from one of the connectors of the module to the high or medium voltage conductor of the high or medium voltage power conductor. The electrical connection from one of the connectors of the module to the high or medium voltage conductor of the high or medium voltage power conductor may be realized with all known means that are suitable to reliably establish a connection between the modules according to the invention and the high or medium voltage power conductor. It may for example comprise a metal conductor that is embedded into an electrically isolating sleeve. It is also possible that the electrical connection is embedded into the isolation of the power conductor. The system also provides at least one low voltage end module providing a low voltage impedance element and an electrical connection to ground or low voltage.

The system according to the invention provides the advantage, that depending on the according application a voltage needs to be measured, for example at a 30 kilo Volt power conductor, it is possible to build the according voltage divider for sensing a voltage by adding as many modules according to the invention as needed. Thus, it is possible to select the number of modules for building a voltage divider for sensing a voltage of a high or medium voltage power conductor as needed for each according application. The higher the voltage is that needs to be measured, the more modules according to the invention can be selected.

The low voltage end module may also provide an electrical connection to low voltage or to electrical ground and it may also provide at least one signal output.

The invention also provides a high or medium voltage grid with a high or medium voltage power conductor comprising at least one module for building a divider for sensing a voltage according to any of the above described embodiments of the module.

The high or medium voltage grid according to the invention with the high or medium voltage power conductor may also comprise a system for building a voltage divider for sensing a voltage as also described above.

The invention will now be described in more detail with reference to the following Figures exemplifying particular embodiments of the invention:
- Fig. 1: a three dimensional schematic view of a module for building a voltage divider for sensing a voltage of an inner conductor of a high or medium voltage power conductor according to the invention;
- Fig. 2: a three dimensional schematic view of a termination skirt with a module for building a voltage divider for sensing a voltage of an inner conductor of a high or medium voltage power conductor according to the invention;
- Fig. 3: a three dimensional view of a high or medium voltage cable end with partially removed outer layers;
- Fig. 4: a three dimensional view of the high or medium voltage cable of Fig. 3 with an insulation tube;
- Fig. 5: a three dimensional view of the high or medium voltage cable of Fig. 3 and 4 with a first termination skirt with a module for building a voltage divider for sensing a voltage of an inner conductor of a high or medium voltage power conductor according to the invention;
- Fig. 6: a three dimensional view of the high or medium voltage cable of Fig. 3 to 5 with the first termination skirt pushed onto the isolation tube and a second termination skirt;
- Fig. 7: a three dimensional view of the high or medium voltage cable of Fig. 3 to 6 with three termination skirts pushed onto the insolation tube;
- Fig. 8: a three dimensional view of the high or medium voltage cable of Fig. 7 with a high or medium voltage end module and a low voltage end module (system for building a voltage divider for sensing a voltage of an inner conductor of a high or medium voltage power conductor according to the invention) and
- Fig. 9: an electrical circuit diagram of the system for building a voltage divider for sensing a voltage of an inner conductor of a high or medium voltage power conductor according to the invention.

Herein below various embodiments of the present invention are described and shown in the drawings wherein like elements are provided with the same reference numbers.

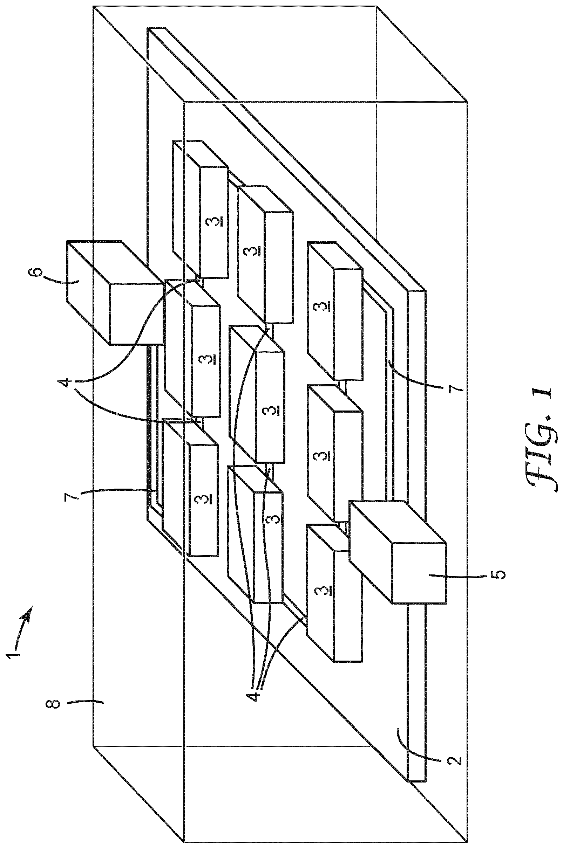

Fig. 1 shows a three dimensional schematic view of a module 1 for building a voltage divider for sensing a voltage of an inner conductor of a high or medium voltage power conductor according to the invention. The module 1 comprises a support 2, for example a printed circuit board, with a plurality of discrete impedance elements 3. The plurality of discrete impedance elements 3 are electrically connected in series as to be operable as a voltage divider for sensing a voltage of an inner conductor of a high or medium voltage power conductor. The electrical connections 4 between the discrete impedance elements 3 are realised with conductive traces 4 on the support 2. The impedance elements 3 are arranged in an s-shaped or zig-zag shaped manor on the printed circuit board 2.

The module 1 further comprises a first connector 5 and a second connector 6. Both connectors 5 and 6 are electrically connected with the discrete impedance elements via conductive traces 7 on the support 2.

The second connector 6 is adapted to be mechanically and electrically connected with a connector identical to the first connector 5 of a further module for building a voltage divider according to the invention. The first connector 5 is adapted to be mechanically and electrically connected with a connector identical to the second connector 6 of a further module 1 for building a voltage divider according to the invention. This enables to build a chain of modules 1 according to the invention, wherein the discrete impedance elements of the modules will be electrically connected in series as to be operable as a voltage divider for sensing a voltage.

Finally, the module 1 according to the invention comprises an encapsulation body 8. The encapsulation body is dimensioned such that the first and the second connector 5 and 6 are still accessible from outside the encapsulation body such that they may be connected to another connector, e. g. from a further module 1. In the embodiment shown in Fig. 1 the encapsulation body 8 has a prismatic or box-shape. The encapsulation body 8 may have any other appropriate shape, such as for example a tubular shape. The encapsulation body 8 is made out of electrically insulating material. It may also be made out of a rigid material in order to protect the elements of the module 1 against mechanical and/or chemical impacts.

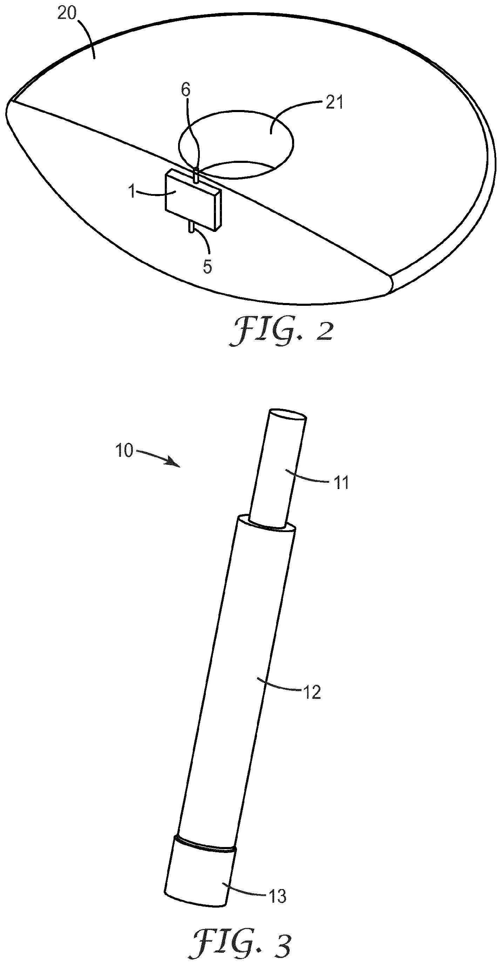

Fig. 2 is a three dimensional schematic view of a termination skirt 20 with a module 1 for building a voltage divider for sensing a voltage of an inner conductor of a high or medium voltage power conductor according to the invention. The skirt 20 comprises a flat ellipsoid shape or a disk shape with a through hole 21 in its middle. The through hole 21 is dimensioned and designed such as to receive a high or medium voltage power conductor. As can be seen in Fig. 2, the module 1 is embedded in the termination skirt 20 such that the two connectors 5 and 6 are accessible from the outside of the skirt 20 and may be mechanically and electrically connected with another connector, e. g. of a similar termination skirt 20 as shown in Fig. 2. Module 1 of Fig. 2 may also comprise a printed circuit board for carrying the impedance elements as well as an encapsulation body, over moulding the printed circuit board, as described above.

Fig. 3 is a three dimensional view of a high or medium voltage cable end of a high or medium voltage cable 10 with partially removed outer layers. The cable provides from the inside to the outside an inner high voltage or medium voltage conductor 11, a cable insulation 12 as well as a semi-conductive outer layer 13. Additional layers of the cable, like for example a cable sheath, are not shown in the drawing.

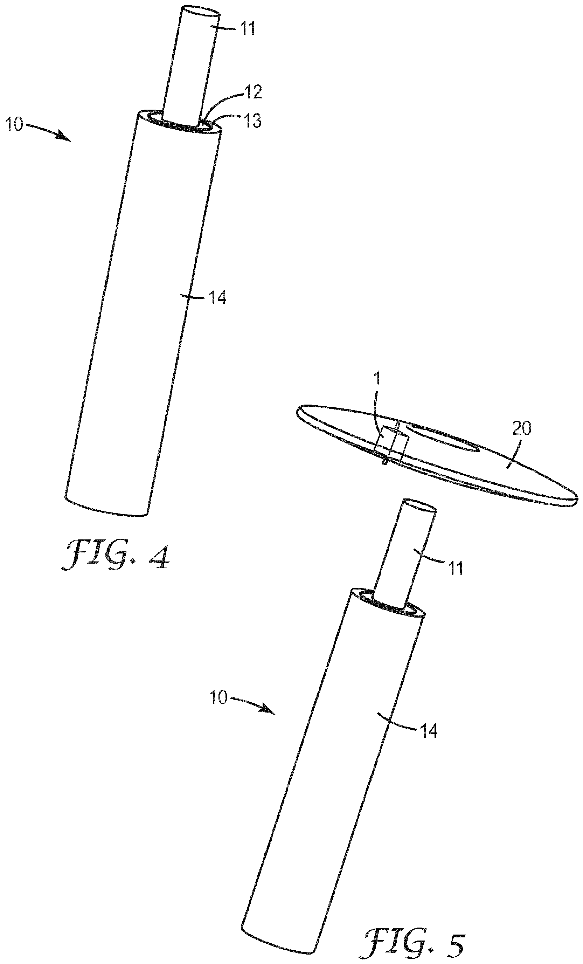

Moving further to Fig. 4, showing a three dimensional view of the end of the high or medium voltage cable 10 of Fig. 3 with an additional insulation tube 14 pushed over the inner conductor 11, the cable insulation 12 as well as the semi-conductive outer layer 13. The additional insulation tube 14 may comprise an inner field control layer (not shown in the drawing), for example a layer with a high permittivity and an outer insulation layer. The insulation tube 14 may be installed by a push on or a cold shrink installation.

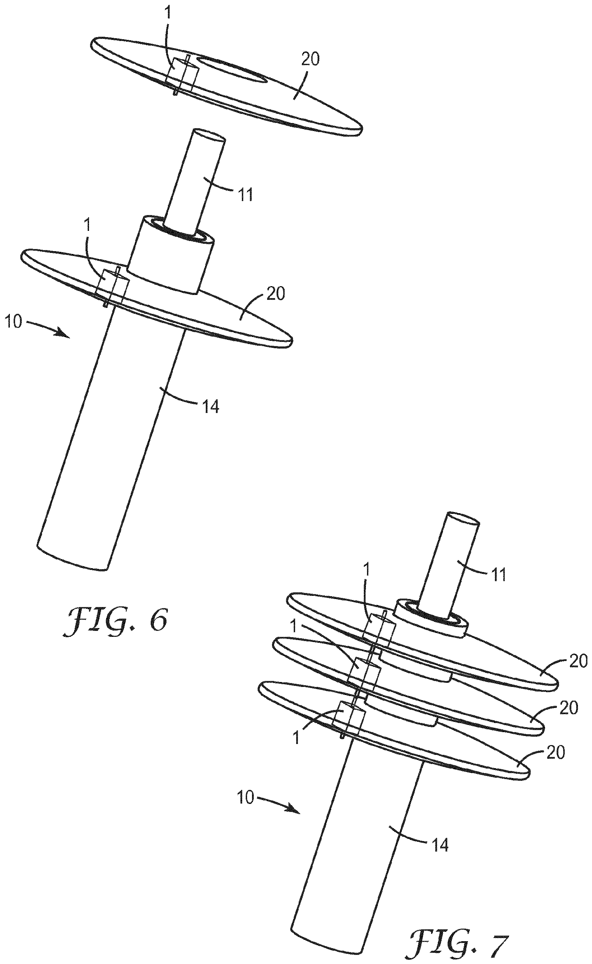

Fig. 5 shows the high or medium voltage cable 10 of Fig. 4 together with the termination skirt 20 of Fig. 2. In order to install the termination skirt 20 on the additional insulation tube 14 of the high or medium voltage cable 10 either push on or cold shrink installation can be used. When a push on installation is used it may be necessary to apply an according grease on top of the additional insulation tube 14 to improve the sliding of the termination skirt 20 over the insulation tube 14. Fig. 6 shows the installed termination skirt 20 on the high or medium voltage cable 10 together if a second to be installed termination skirt 20. Fig. 7 shows the high or medium voltage cable 10 with three termination skirts 20. The termination skirts 20 are positioned over the additional insulation tube 14. They are mechanically and electrically connected with each other over the first and second connectors 5 and 6 of the module 1 for building a voltage divider for sensing a voltage according to the invention.

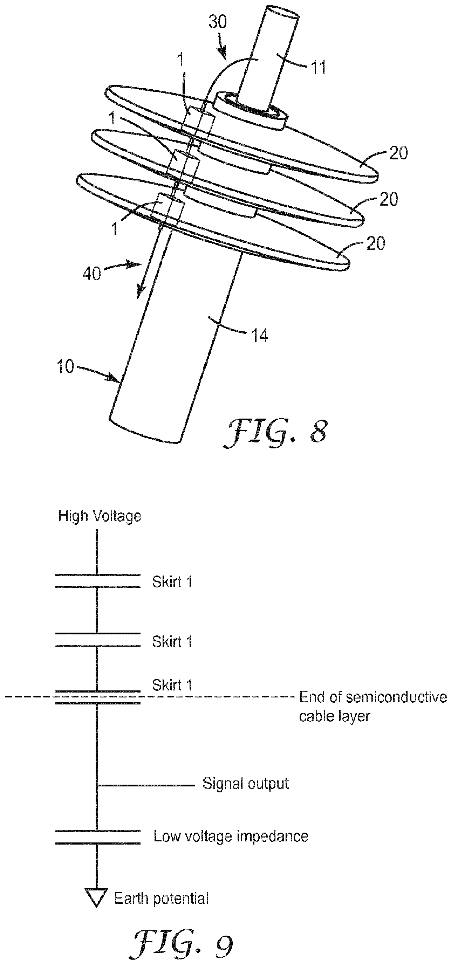

In Fig. 8 the high or medium voltage end module and the low voltage end module of the system for building a voltage divider for sensing a voltage of an inner conductor of a high or medium voltage power conductor are indicated. On top of the three termination skirts 20 the high or medium voltage end module 30 is indicated, which provides an electrical connection from the module 1 inside of the upper termination skirt 20 to the high or medium voltage cable conductor 11. On the lower side of the three termination skirts the low voltage end module 40 is indicated. It may provide a low voltage impedance. It is also possible, that the low voltage impedance element is integrated in the module 1 of the lower termination skirt 20. In this case the low voltage end module 40 comprises a connection to electrical ground and a signal output (not shown in the drawings). The signal output and the earth potential wires have to be installed on top of the semi-conductive layer 13 of the high or medium voltage cable 10 which has earth potential in order to avoid any discharges.

Fig. 9 is the electrical circuit diagram of the system for building a voltage divider for sensing a voltage of an inner conductor of a high or medium voltage power conductor shown in Fig. 8. From the top, the diagram shows the connection to the high or medium voltage conductor, the impedances for each of the three termination skirts, the signal output, the low voltage impedance as well as the connection to electrical ground.

## Claims

1. A module (1) for building a voltage divider for sensing a voltage of an inner conductor of a high or medium voltage power conductor, the module comprising
- at least one discrete impedance element (3),
- a first connector (5) and a second connector (6), wherein the second connector is adapted to be mechanically and electrically connected with a connector identical to the first connector of a further module for building the voltage divider according to the invention, and wherein the first connector is adapted to be mechanically and electrically connected with a connector identical to the second connector of a further module for building the voltage divider according to the invention,
- wherein the at least one impedance element is electrically connected with the first and the second connector, and
- wherein the module further comprises mechanical fixing means (21) for fixing the module to a high or medium voltage power conductor.

2. The module according to claim 1, wherein the module (1) comprises two or more discrete impedance elements (3) that are electrically connected in series as to be operable as a voltage divider for sensing a voltage of an inner conductor of the high or medium voltage power conductor.

3. The module according to claim 1 or 2, wherein the module (1) comprises a printed circuit board (2) carrying the at least one discrete impedance element (3).

4. The module according to any of the preceding claims, wherein the module (1) comprises an encapsulation body (8), in which the at least one discrete impedance element (3) as well as the first and the second connector (5, 6) are encapsulated such that the first and the second connector are accessible from the outside of the module.

5. The module according to claim 4, wherein the module (1) comprises an additional housing (20) enclosing the encapsulation body (8) such that the first and the second connector (5, 6) are accessible from the outside of the module (1).

6. The module according to claim 5, wherein the additional housing (20) and/or the encapsulation body (8) comprises the mechanical fixing means for fixing the module to a high or medium voltage power conductor.

7. The module according to claim 5 or claim 6, wherein the additional housing (20) and/or the encapsulation body (8) comprises a receiving space (21) for receiving a section of the high or medium voltage conductor such that the additional housing and/or the encapsulation body surrounds the high or medium voltage power conductor.

8. The module according to any of the claims 5 to 7, wherein the additional housing (20) and/or the encapsulation body (8) comprises the shape of a termination skirt.

9. The module according to any of the preceding claims, wherein the discrete impedance elements (3) comprise one or more resistors, and/or one or more capacitors, and/or one or more inductances.

10. The module according to any of the preceding claims, wherein the discrete impedance elements (3) are arranged in the module (1) as a straight chain or as a z-shaped chain.

11. A module (1) according to any of the preceding claims in combination with a second module (1) according to any of the preceding claims, wherein the two modules are mechanically and electrically connected with each other such that their discrete impedance elements (3) are electrically connected in series as to be operable as a voltage divider for sensing a voltage of an inner conductor of the high or medium voltage power conductor.

12. A system for building a voltage divider for sensing a voltage of an inner conductor of a high or medium voltage power conductor, the system comprising:
- at least one module (1) for building a voltage divider for sensing a voltage of a high or medium voltage power conductor according to any of the claims 1 to 10,
- at least one high or medium voltage end module (30) providing an electrical connection from one of the first or second connectors (5, 6) of the module and the high or medium voltage power conductor (11), and
- at least one low voltage end module (40) providing a low voltage impedance element (3) and an electrical connection to ground or low voltage.

13. The system according to claim 12, wherein the number of modules (1) for building a voltage divider for sensing a voltage of a high or medium voltage power conductor according to claims 1 to 10 can be selected according to the application in that the sensor is used.

14. The system according to claim 12, wherein the low voltage end module (40) may provide an electrical connection to earth potential and at least one signal output.

15. A high or medium voltage grid with a high or medium voltage power conductor comprising at least one module for building a divider for sensing a voltage according to any of the claims 1 to 10.

16. A high or medium voltage grid with a high or medium voltage power conductor comprising a system for building a voltage divider for sensing a voltage according to any of the claims 12 to 14.
